# EUROPEAN PATENT SPECIFICATION

(11) **EP 4 598 292 B1**
(45) Date of publication and mention of the grant of the patent: **05.08.2026**
(21) Application number: 24305175.2
(22) Date of filing: 31.01.2024
(51) Int. Cl.: H05K 7/20

(54) **THERMAL REGULATION SYSTEM FOR A BACK-UP SYSTEM FOR A DATA CENTER**
WÄRMEREGULIERUNGSSYSTEM FÜR EIN SICHERUNGSSYSTEM FÜR EIN DATENZENTRUM
SYSTÈME DE RÉGULATION THERMIQUE POUR UN SYSTÈME DE SECOURS POUR UN CENTRE DE DONNÉES

(43) Date of publication of application: 06.08.2025
(73) Proprietor: OVH, 59100 Roubaix (FR)
(72) Inventor: LACHEVRE, Maxime, 59510 Hem (FR); HAMIDI, Youssef, 59100 Roubaix (FR)
(74) Representative: BCF Global

(56) References cited:
- US-A1- 2016 290 154
- US-A1- 2022 087 076
- US-A1- 2022 390 178

## Description

### FIELD OF TECHNOLOGY

The present technology generally relates to thermal regulation systems for a back-up system, such as a back-up generator, associated with data centers.

### BACKGROUND

Data centers are specialized facilities designed to house and manage a large number of electronic equipment, such as servers, processors, etc. for the purpose of processing, storing, and transmitting data.

To ensure uninterrupted service and continuous operations, data centers rely on back-up systems, such as back-up generators, in case of electrical grid failures or other power disruptions. The start-up and performance of the back-up generators may be impacted by various weather conditions (e.g., cold weather conditions and/or climates). To mitigate impacts of weather on performance, back-up generators are equipped with a thermal regulation system to pre-heat the back-up generator's cooling system, ensuring the back-up generator can start and operate reliably. Typically, thermal regulation systems use coolant heaters, such as water coolant heaters, to regulate temperature of the back-up generator and are controlled through temperature sensors to raise and/or maintain a coolant temperature of approximately 40°C.

For example, a conventional approach is prescribed by US Pub. No. 2022/0390178 discloses a cooling arrangement and method for cooling a heat source that comprises a closed loop, a semi-open loop and at least one fan. The closed loop comprises a primary side of a liquid-to-liquid heat exchanger receiving a first cooling fluid heated by the heat source, a first air-to-liquid heat exchanger downstream said primary side, and a first pump returning the first cooling fluid to the heat source. The semi-open loop comprises a tank storing a second cooling fluid, a second pump drawing the second cooling fluid from the tank, a secondary side of the liquid-to-liquid heat exchanger receiving the second cooling fluid from the second pump, an evaporating pad downstream said secondary side, and an inlet fluidly connected to a source of the second cooling fluid.

Another example of conventional approaches is US Pub. No. 2016/0290154, which discloses techniques for providing power to a data center that includes transferring heat from a computer data center to warm a fluid stored within an energy regeneration system; circulating the warmed fluid to a flow of compressed gas stored within the energy regeneration system during a discharging process that expands the compressed gas; generating energy with the energy generation system from the discharging process; and providing at least a portion of the generated energy to the computer data center as electrical power.

In yet another example of conventional approaches is US Pub. No. 2022/0087076, which discloses a high temperature electronic device thermal management system. Data centers contain many large racks of computer servers with electronic devices that generate heat. For the devices to function properly, they must not exceed a maximum temperature. Typical techniques for thermal management of data center electronics involve using sub-ambient temperature coolants via refrigeration cycles, requiring significant input energy to operate. The present thermal management system includes a flow management system to produce elevated coolant temperatures while sustaining safe device temperatures. This allows the coolant to reject to ambient temperatures globally and year-round, enabling reduced energy usage by no longer requiring refrigeration cycles. Further, operation at or above 55° C. would allow for implementation of additional waste heat recovery processes with increased energy efficiency.

With this said, there is remains an interest in developing an improved and more efficient system for the thermal regulation of a back-up system associated with data centers.

### SUMMARY

The embodiments of the present disclosure are based on developers' understanding of the drawbacks associated with conventional thermal regulation systems associated with back-up systems, such as back-up generators and electric batteries.

Specifically, the developers have identified inefficiencies of conventional back-up systems which have incorporated therein closed loop thermal regulation systems. The thermal regulation of the back-up systems are powered by electricity, ranging between 4kW to 18kW, to raise and/or maintain a predetermined temperature. Typically, these systems include a heating element connected to an external power source (e.g., electrical grid).

Back-up generators commonly use coolant heaters, such as water coolant heater. A coolant fluid is circulated, in a closed loop, between the coolant heater and the back-up generator to regulate temperature of the back-up generator. Similarly, electric batteries use an electric heater to transfer heat to a coolant fluid which is circulated in a closed loop between the electric battery and the heater.

These thermal regulation systems are operated constantly during cooler seasons of the year, leading to significant power consumption resulting in higher operational costs and an increased environmental impact due to increased carbon emissions. Additionally, continuous operation of the thermal regulation system leads to increased wear and tear of the equipment which contributes to larger operational and capital expenditures to maintain, replace, and/or purchase new equipment. Moreover, these systems usually operate independently from other infrastructures within the data center which limits opportunities for integration, scalability, and energy efficiency improvements.

Broadly, the present disclosure provides a system for thermal regulation of a back-up system using thermal energy from a data center. Specifically, a thermal regulation system thermally connects a back-up system to a data center to transfer heat from the data center to the back-up system, thereby pre-heating the back-up system to a temperature required for proper operation and function. This mitigates the need for the back-up system to have its own dedicated closed-loop thermal regulation system which operates continuously. Therefore, in certain embodiments, power consumption is significantly reduced.

According to one aspect of the present technology, there is provided a data center system as defined by the independent claim 1.

Further features are defined by the appended claims 2-9.

In the context of the present specification, unless expressly provided otherwise, electronic equipment may refer, but is not limited to, "servers", "electronic devices", "operation systems", "systems", "computer-based systems", "controller units", "monitoring devices", "control devices" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

It must be noted that, as used in this specification and the appended claims, the singular form "a", "an" and "the" include plural referents unless the context clearly dictates otherwise.

As used herein, the term "and/or" is to be taken as specific disclosure of each of the two specified features or components with or without the other. For example "A and/or B" is to be taken as specific disclosure of each of (i) A, (ii) B and (iii) A and B, just as if each is set out individually herein.

Embodiments of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of embodiments of the present technology will become apparent from the following description, the accompanying drawings, and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 illustrates a functional block diagram of a data center system with a thermal regulation system connected to a data center and a back-up system, in accordance with embodiments of the present disclosure;
Figure 2 illustrates a functional block and circuit diagram of the thermal regulation system of Figure 1 including a heat transfer module, in accordance with embodiments of the present disclosure;
Figure 3 illustrates a functional block and circuit diagram of the thermal regulation system of Figure 1 with the heat transfer module of Figure 2, the thermal regulation system including a pump associated with a back-up system fluid circuit, in accordance with embodiments of the present disclosure;
Figure 4 illustrates a functional block and circuit diagram of the thermal regulation system of Figure 1 with the heat transfer module of Figure 2, the thermal regulation system including sensors associated with a back-up system fluid circuit, in accordance with embodiments of the present disclosure;
Figure 5 illustrates a functional block and circuit diagram of the thermal regulation system of Figure 1 with an alternative embodiment of a heat transfer module, in accordance with embodiments of the present disclosure;
Figure 6 illustrates a functional block and circuit diagram of the thermal regulation system of Figure 1 with the heat transfer module of Figure 5 including a pump associated with an intermediate fluid circuit and a pump associated with a back-up system fluid circuit, in accordance with embodiments of the present disclosure;
Figure 7 illustrates a functional block and circuit diagram of the thermal regulation system of Figure 1 with the heat transfer module of Figure 5 including a pump and sensors associated with an intermediate fluid circuit, in accordance with embodiments of the present disclosure;
Figure 8 illustrates a functional block and circuit diagram of the data center system of Figure 1 including a first connector fluidly connecting the thermal regulation system to the data center and a second connector fluidly connecting the thermal regulation system to the back-up system, in accordance with embodiments of the present disclosure.

It should be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remain within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future.

Data centers house many rack-mounted electronic equipment, such as servers, processors, etc. In use, electronic processing assemblies generate a significant amount of heat that is quelled or at least dissipated in order avoid electronic component failures and ensure continued efficient operation. To regulate and evacuate the heat generated by the electronic equipment, data centers typically implement heat management systems to transfer excess heat from electronic equipment to a coolant fluid circulating through the data center. Heat generated by the electronic equipment is transferred to the coolant fluid, raising the temperature of the coolant fluid while lowering the temperature of the electronic equipment. Typically, the warmed coolant fluid exits the data center where it circulates through a dry cooler which cools the coolant fluid using ambient air. The coolant fluid exits from the dry cooler and is re-circulated through the data center.

With these fundamental principles in place, we will now consider some non-limiting examples to illustrate various implementations of aspects of the present disclosure.

Broadly, embodiments of the present disclosure are directed to a thermal regulation system which uses the thermal energy expelled from data centers to regulate temperature of a back-up system, such as a back-up generator and/or a back-up electric battery. The thermal regulation system is thermally connected to the data center and the back-up system to allow for the transfer thermal energy.

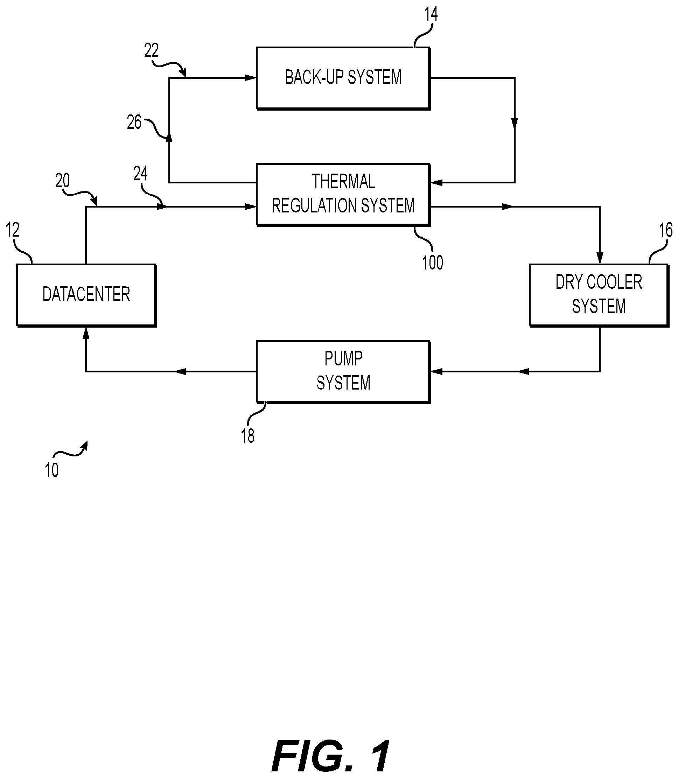

With reference to Figure 1, a functional block diagram of a data center system 10 is depicted. The data center system 10 includes a data center 12 which houses electronic equipment such as servers, processors, etc. configured to process, store, and transmit data. The data center 12 includes a cooling system to circulate a data center coolant fluid 24 through the data center 12 to dissipate heat of the electronic equipment.

To ensure uninterrupted service and continuous operations, the data center system 10 includes a back-up system 14 electrically connected to the data center 12 to provide electricity in the event of an electrical grid failure and/or other power disruptions. In some embodiments, the back-up system includes at least one back-up generator. In other embodiments, the back-up system 14 may include at least one electric battery. It is appreciated that, in alternative embodiments, the back-up system 14 may include a combination of back-up generators and electric batteries.

The data center system 10 further includes a thermal regulation system 100 fluidly connected to the data center 12 and constitutes at least a portion of the cooling system of the data center 12. The thermal regulation system 100 is fluidly connected to the back-up system 14. The thermal regulation system 100 thermally connects the data center 12 with the back-up system 14 such that thermal energy is transferred between the data center 12 and the back-up system 14. Specifically, the thermal regulation system 100 facilitates heat management of the data center 12 and temperature control of the back-up system 14 by utilizing the heat generated by the electronic equipment of the data center 12 to raise and/or maintain a predetermined temperature of the back-up system 14, thereby mitigating impacts of cold weather conditions on the performance and operation of the back-up system 14. In some instances, the predetermined temperature is approximately 40°C. This means that a separate thermal regulation system for pre-heating and/or maintaining temperature of the back-up system 14 is not required. The thermal regulation system 100 will be described in further detail below. In some circumstances, the thermal regulation system 100 may be referred to as a heat recovery system.

The data center system 10 includes a dry cooler system 16 to further facilitate in heat management of the data center 12. The dry cooler system 16 includes at least one dry cooler assembly fluidly connected to the data center 12. Typically, a dry cooler assembly uses heat exchangers and fans to lower a temperature of the data center coolant fluid 24. Specifically, the data center coolant fluid 24 is received by the heat exchangers of the dry cooler assembly where the data center coolant fluid 24 transfers heat to ambient air, pulled in by the fans, thereby cooling the data center coolant fluid 24. The heated air is then discharged and the now cooled data center coolant fluid 24 is eventually recirculated back to the data center 12. It is contemplated that, in alternative embodiments, the dry cooler system 16 may be omitted.

The data center system 10 further includes a pump system 18 fluidly connected to the data center 12 and the dry cooler system 16 to facilitate circulation of the data center coolant fluid 24 between the dry cooler system 16 and the data center 12. It is contemplated that, in some embodiments, multiple pump systems 18 may be positioned along the data center fluid circuit 20 to facilitate circulation between the data center 12, the thermal regulation system 100, and the dry cooler system 16. It is contemplated that, in alternative embodiments, the pump system 18 may be omitted.

As depicted in Figure 1, the data center system 10 includes a data center fluid circuit 20 and a back-up system fluid circuit 22. The data center fluid circuit 20 circulates the data center coolant fluid 24 between the data center 12, the thermal regulation system 100, the dry cooler system 16, and the pump system 18. The data center coolant fluid 24 may be a dielectric liquid or a non-dielectric liquid, for example and without limitation, water, glycol, oil, or a combination thereof. In this embodiment, the data center coolant fluid 24 is water.

The back-up system fluid circuit 22 circulates a back-up system coolant fluid 26 between the back-up system 16 and the thermal regulation system 100. The back-up system coolant fluid 26 may be a dielectric liquid or a non-dielectric liquid, for example and without limitation, water, glycol, oil, or a combination thereof. In this embodiment, the back-up system coolant fluid 26 is water. As depicted in Figure 1, the back-up system fluid circuit 22 forms a closed loop circuit. In other words, the back-up system coolant fluid 26 flows from the back-up system 16 through the thermal regulation system 100 and returns to the back-up system 16. In alternative embodiments, the back-up system coolant fluid 26 may flow from a coolant source.

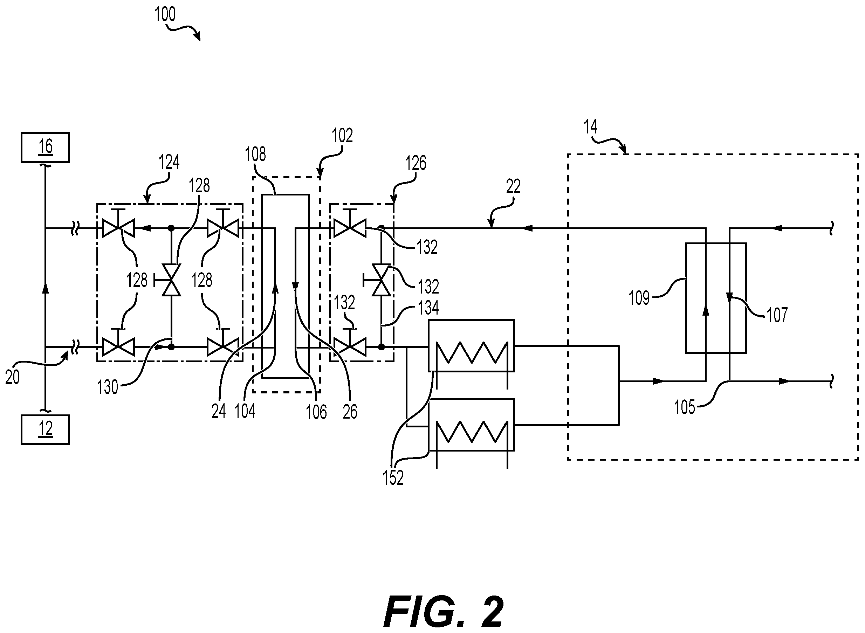

With reference to Figures 2 to 7, various embodiments of the thermal regulation system 100 will now be described in detail. The thermal regulation system 100 includes a heat transfer module 102 thermally connecting the data center 12 to the back-up system 14.

The thermal regulation system 100 includes a data center fluid conduit 104 positioned through the heat transfer module 102. The data center fluid conduit 104 constitutes at least a portion of the data center fluid circuit 20 such that the data center coolant fluid 24 circulates from the data center 12 through the heat transfer module 102 via the data center fluid conduit 104. The thermal regulation system 100 further includes a back-up system fluid conduit 106 positioned through the heat transfer module 102. The back-up system fluid conduit 106 constitutes at least a portion of the back-up system fluid circuit 22 such that the back-up system coolant fluid 26 circulates through the heat transfer module 102 to the back-up system 14 via the back-up system fluid conduit 106. The data center fluid conduit 104 and the back-up system fluid conduit 106 are thermally connected via the heat transfer module 102 and heat is transferred from the data center coolant fluid 24 to the back-up system coolant fluid 26. The back-up system coolant fluid 26 is then circulated to the back-up system 14 to pre-heat and/or maintain the temperature of the back-up system 14 to the predetermined temperature.

As depicted in Figures 2 to 4, the heat transfer module 102 includes a liquid-to-liquid heat exchanger 108. In some embodiments, the heat exchanger 108 is a plate heat exchanger. The data center fluid conduit 104 is positioned through a first side of the heat exchanger 108 and the back-up system fluid conduit 106 is positioned through a second side of the heat exchanger 108 such that heat is transferred from the data center coolant fluid 24 to the back-up system coolant fluid 26.

During use, the data center coolant fluid 24 flows through the data center 12 where heat is transferred from the electronic equipment to the data center coolant fluid 24, lowering a temperature of the electronic equipment and raising the temperature of the data center coolant fluid 24. The data center coolant fluid 24 circulates from the data center 12 to the heat exchanger 108 via the data center fluid conduit 104. The data center coolant fluid 24 exits from the heat exchanger 108 and flows towards the dry cooler system 16.

The back-up system coolant fluid 26 circulates from the back-up system 14 to the heat exchanger 108. The back-up system coolant fluid 26 flows through the heat exchanger 108 via the back-up system fluid conduit 106. Upon exiting the heat exchanger 108, the back-up system coolant fluid 26 returns to the back-up system 14.

Within the heat exchanger 108, the back-up system coolant fluid 26 has a temperature lower than the temperature of the data center coolant fluid 24 (which has been raised by the electronic equipment within the data center 12). As a result, heat is transferred from the warmer data center coolant fluid 24 to the cooler back-up system coolant fluid 26 within the heat exchanger 108. Thus, the temperature of the data center coolant fluid 24 is lowered and the temperature of the back-up system coolant fluid 26 is raised.

The cooled data center coolant fluid 24 exits the heat exchanger 108 and flows through the dry cooler system 16 where the temperature may be further reduced before eventually being returned to the data center 12 to, once again, facilitate heat management of the electronic equipment.

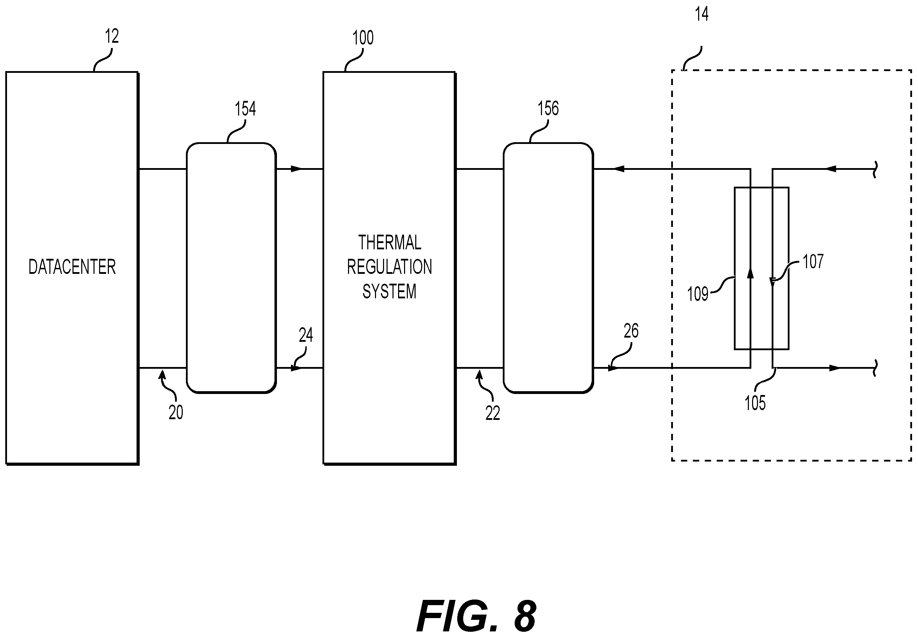

The warmed back-up system coolant fluid 26 exits the heat exchanger 108 and flows towards the back-up system 14. In some embodiments, the back-up system 14 includes an internal fluid conduit 105 for circulating an internal coolant fluid 107 (as depicted in Figures 2 and 8). The back-up system 14 may further include a back-up system heat transfer module 109, thermally connecting the back-up system 14 and the data center 12 via the thermal regulation system 100. The back-up heat transfer module 109 transfers heat from the back-up system coolant fluid 26 to the internal coolant fluid 105 which is then circulated through the back-up system 14 to pre-heat and/or maintain the back-up system 14 to the predetermined temperature. In some instances, the back-up system heat transfer module 109 may include a liquid-to-liquid heat exchanger, such as a plate heat exchanger.

In other embodiments, the back-up system heat transfer module may be omitted. Instead, the back-up system coolant fluid 26 may circulate through the back-up system 14 to facilitate in pre-heating and/or maintaining the temperature of the back-up system 14 to the predetermined temperature.

Exemplary temperatures along of the data center coolant fluid 24, as it flows through the data center fluid circuit 20 will now be presented. In certain embodiments, the data center coolant fluid 24 exits the data center 12 at a temperature of about 47°C. The data center coolant fluid 24 circulates from the data center 12 to the heat exchanger 108 of the thermal regulation system 100. As the data center coolant fluid 24 flows through the heat exchanger 108, heat is transferred from the data center coolant fluid 24 to the back-up system coolant fluid 26, where the data center coolant fluid 24 may experience a temperature change of up to 5°C. In one example, the data center coolant fluid 24 is about 43°C upon exiting the heat exchanger 108. The data center coolant fluid 24 circulates from the heat exchanger 108 to the dry cooler system 16 where the temperature of the data center coolant fluid 24 is further reduced. Upon exiting the dry cooler system 16, a temperature of the data center coolant fluid 24 is about 27°C before being circulated through the data center 12.

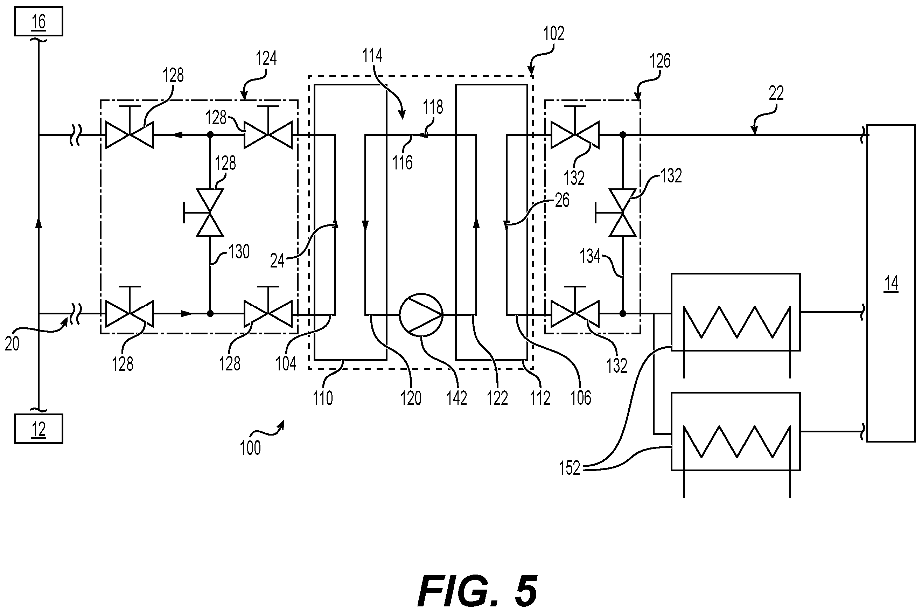

An alternative embodiment of the heat transfer module 102 is depicted in Figures 5 to 7. In this embodiment, the heat transfer module 102 includes a first liquid-to-liquid heat exchanger 110 and a second liquid-to-liquid heat exchanger 112 and an intermediate fluid circuit 114 therebetween. In some embodiments, each of the first heat exchanger 110 and the second heat exchanger 112 are heat exchanger plates. The intermediate fluid circuit 114 includes an intermediate fluid conduit 116 circulating an intermediate coolant fluid 118. The intermediate coolant fluid 118 may be a dielectric liquid or a non-dielectric liquid, for example and without limitation, water, glycol, oil, or a combination thereof. In this embodiment, the intermediate coolant fluid 118 is water. In some embodiments, the intermediate fluid circuit 114 is a closed loop circuit. In alternative embodiments, the intermediate fluid circuit 114 may be connected to a source for supplying the intermediate coolant fluid 118.

The data center fluid conduit 104 is positioned through a first side of the first heat exchanger 110 and a portion 120 of the intermediate fluid conduit 116 is positioned through a second side of the first heat exchanger 110. Thus, heat is transferred from the data center coolant fluid 24 to the intermediate coolant fluid 118 flowing through the portion 120 of the intermediate fluid conduit 116 positioned through the first heat exchanger 110.

A portion 122 of the intermediate fluid conduit 116 is positioned through a first side of the second heat exchanger 112 and the back-up system fluid conduit 106 is positioned through a second side of the second heat exchanger 112. Thus, heat is transferred from the intermediate coolant fluid 118 flowing through the portion 122 of the intermediate fluid conduit 116 positioned through the second heat exchanger 112 to the back-up system coolant fluid 26.

During use, the data center coolant fluid 24 flows through the cooling system of the data center 12 where heat is transferred from the electronic equipment to the data center coolant fluid 24, lowering a temperature of the electronic equipment and raising a temperature of the data center coolant fluid 24. The data center coolant fluid 24 circulates from the data center 12 to the first heat exchanger 110 via the data center fluid conduit 104. The data center coolant fluid 24 exits from the first heat exchanger 108 and flows towards the dry cooler system 16. The cooled data center coolant fluid 24 flows through the dry cooler system 16 where the temperature is further reduced. From the dry cooler system 16, the data center coolant fluid 24 is returned to the data center 12 to, once again, facilitate heat management of the electronic equipment.

Within the first heat exchanger 110, the temperature of the data center coolant fluid 24 is higher than a temperature of the intermediate coolant fluid 118 circulating through the first heat exchanger 110. As a result, heat is transferred from the warmer data center coolant fluid 24 to the cooler intermediate coolant fluid 118. The temperature of the data center coolant fluid 24 is lowered while the temperature of the intermediate coolant fluid 118 flowing through the portion 120 of the intermediate fluid conduit 116 is raised. The warmed intermediate coolant fluid 118 exits the first heat exchanger 110 and flows towards the second heat exchanger 112.

The back-up system coolant fluid 26 circulates from the back-up system 14 to the second heat exchanger 112. The back-up system coolant fluid 26 flows through the second heat exchanger 112 via the back-up system fluid conduit 106. Upon exiting the heat second exchanger 112, the back-up system coolant fluid 26 returns to the back-up system 14.

Within the second heat exchanger 112, the back-up system coolant fluid 26 has a temperature lower than the temperature of the intermediate coolant fluid 118 (which has been raised by the transfer of heat in the first heat exchanger 110). Heat is transferred from the warmer intermediate coolant fluid 118 to the cooler back-up system coolant fluid 26 within the second heat exchanger 112. As a result, the temperature of the intermediate coolant fluid 118 circulating through the portion 122 of the intermediate fluid conduit 116 is lowered while the temperature of the back-up system coolant fluid 26 is raised. Upon exiting the second heat exchanger 112, the cooled intermediate coolant fluid 118 flows towards the first heat exchanger 110.

The warmed back-up system coolant fluid 26 exits the second heat exchanger 112 and flows towards the back-up system 26. In some embodiments, the back-up system 14 includes an internal fluid conduit 105 for circulating an internal coolant fluid 107 (as depicted in Figures 2 and 8). The back-up system 14 may further include a back-up system heat transfer module 109, thermally connecting the back-up system 14 and the data center 12 via the thermal regulation system 100. The back-up heat transfer module 109 transfers heat from the back-up system coolant fluid 26 to the internal coolant fluid 107 which is then circulated through the back-up system 14 to pre-heat and/or maintain the back-up system 14 to the predetermined temperature. In some instances, the heat transfer module may include a liquid-to-liquid heat exchanger, such as a plate heat exchanger.

In other embodiments, the back-up system heat transfer module may be omitted. Instead, the back-up system coolant fluid 26 may circulate through the back-up system 14 to facilitate in pre-heating and/or maintaining the temperature of the back-up system 14 to the predetermined temperature.

The thermal regulation system 100 may further include a bypass system to bypass flow away from the heat transfer module 102. As depicted in Figures 2 to 7, the thermal regulation system 100 includes a first and a second bypass system 124, 126.

The first bypass system 124 is associated with the data center fluid circuit 20. Specifically, the first bypass system 124 is fluidly connected to the data center fluid conduit 104 to redirect flow of the data center coolant fluid 24. In some embodiments, the first bypass system 124 comprises at least one of: a bypass valve, a bypass pump, a bypass channel, a bypass sensor, and other bypass components which cooperate to alter the flow of the data center coolant fluid 24. For example, as depicted in Figures 2 to 7, the first bypass system 124 includes a plurality of bypass valves 128 disposed along the data center fluid conduit 104 and further includes the bypass channel 130 to divert flow away from the heat transfer module 102.

The second bypass system 126 is associated with the back-up system fluid circuit 22. Specifically, the second bypass system 126 is fluidly connected to the back-up system fluid conduit 106 to redirect flow of the back-up system coolant fluid 26. In some embodiments, the second bypass system 126 comprises at least one of: a bypass valve, a bypass pump, a bypass channel, a bypass sensor, and other bypass components which cooperate to alter the flow of the back-up system coolant fluid 26. For example, as depicted in Figures 2 to 7, the second bypass system 126 includes a plurality of bypass valves 132 disposed along the back-up system fluid conduit 106 and further includes the bypass channel 134 to divert flow away from the heat transfer module 102.

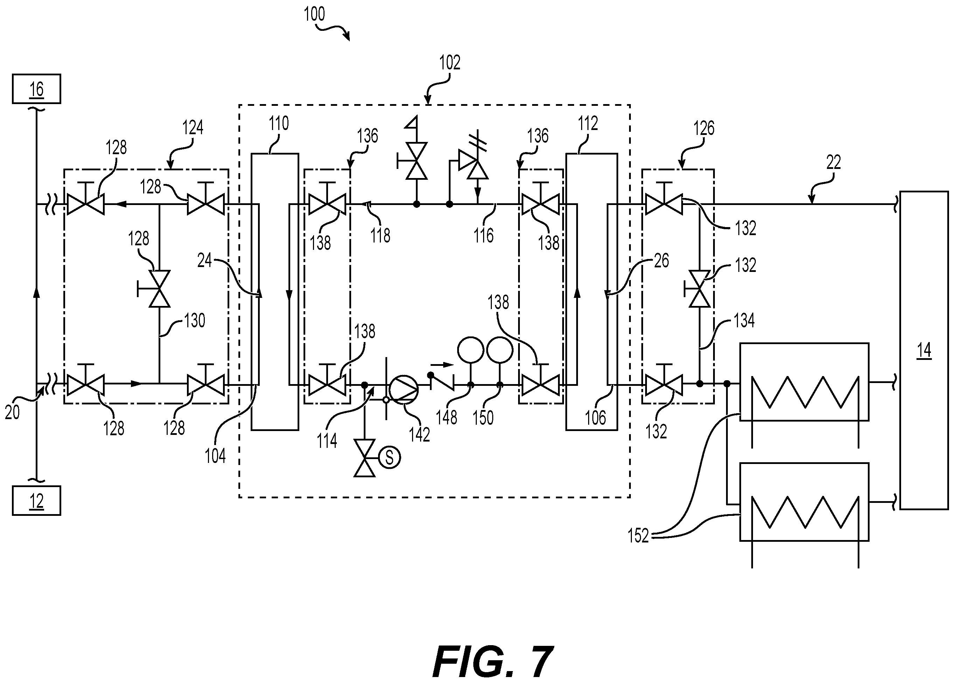

With specific reference to Figure 7, the thermal regulation system 100 may further include an intermediate bypass system 136 associated with the intermediate fluid circuit 114 to redirect flow of the intermediate coolant fluid 118. In some embodiments, the intermediate bypass system 136 comprises of at least one of: a bypass valve, a bypass pump, a bypass channel, a bypass sensor, and other bypass components which cooperate to alter the flow of the intermediate system coolant fluid 118. For example, as depicted in Figure 7, the intermediate bypass system 136 includes a plurality of bypass valves 138.

It is appreciated that the thermal regulation system 100 may include any number and any combination of the first bypass system 124, the second bypass system 126, and the intermediate bypass system 136 (if applicable). It is contemplated that, in alternative embodiments, the bypass systems 124, 126, 136 may be omitted.

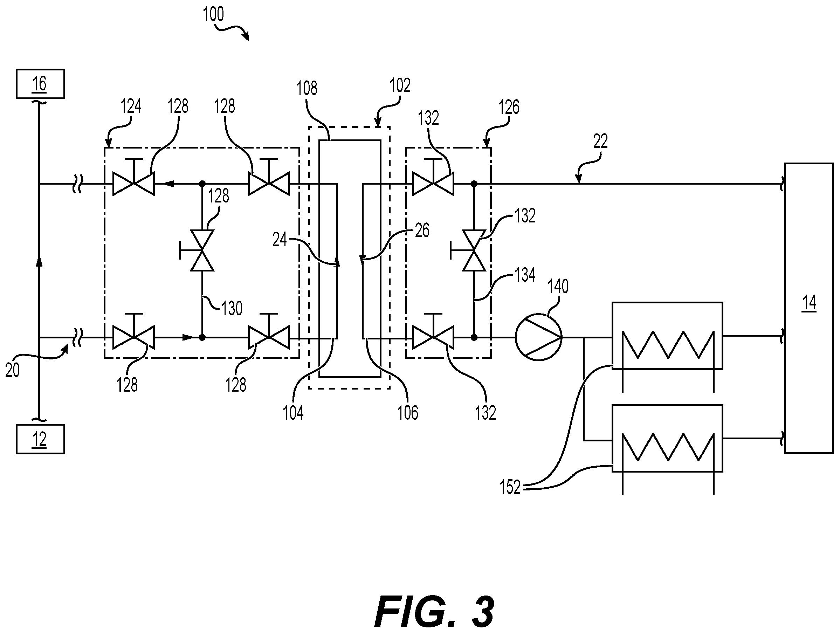

With reference to Figures 3, 5, 6, and 7, the thermal regulation system 100 may further include at least one pump to facilitate circulation through the associated fluid circuit.

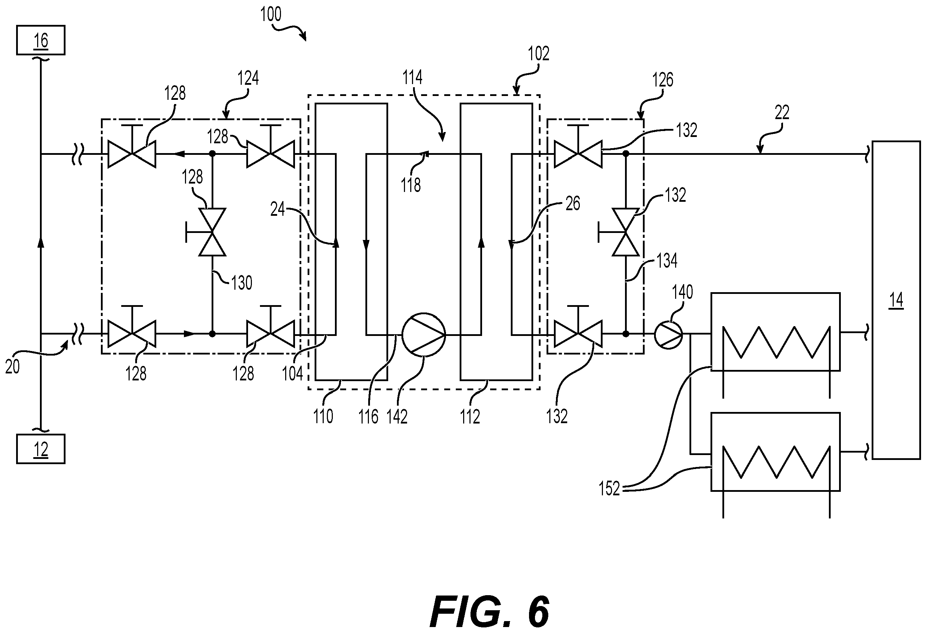

As depicted in Figures 3 and 6, the thermal regulation system 100 includes a pump 140 associated with the back-up system fluid circuit 22. The pump 140 is fluidly connected to the back-up system conduit 106 to facilitate circulation of the back-up system coolant fluid 26.

As depicted in Figures 5 to 7, the thermal regulation system 100 includes a pump 142 associated with the intermediate fluid circuit 114. The pump 142 is fluidly connected to the intermediate fluid conduit 116 to facilitate circulation of the intermediate coolant fluid 118.

It is contemplated that a pump may be associated with the data center fluid circuit 20 (not shown), fluidly connected to the data center fluid conduit 104, to facilitate circulation of the data center coolant fluid 24.

It is appreciated that the thermal regulation system 100 may include any number of and any combination of pumps associated with the data center fluid circuit 20, the back-up system fluid circuit 22, and the intermediate fluid circuit 114 (if applicable). It is contemplated that, in alternative embodiments, the pump(s) may be omitted.

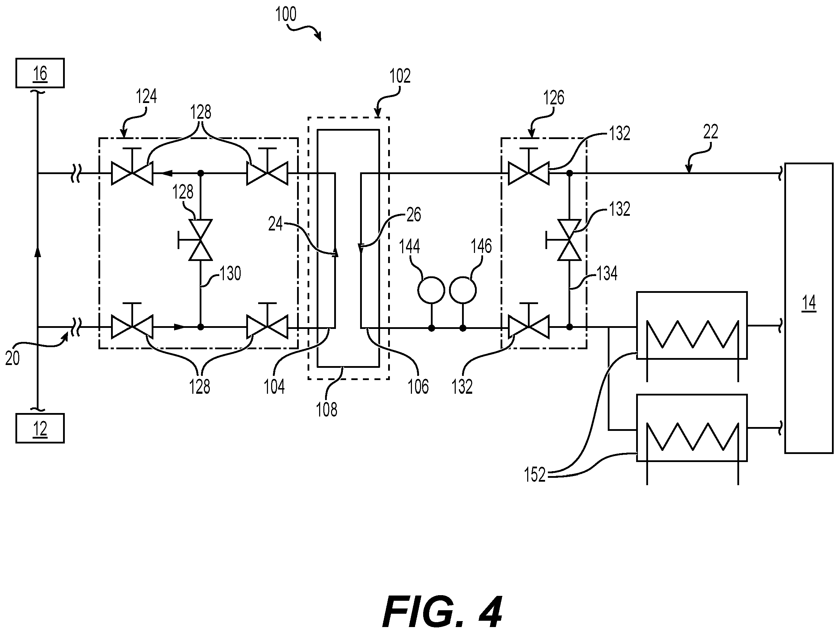

With reference to Figures 4 and 7, the thermal regulation system 100 includes a sensor to detect a fluid property of the respective coolant fluid. In some embodiments, the thermal regulation system 100 may include at least one of: a pressure sensor, a temperature sensor, a flow sensor, or any other sensor for detecting a fluid property of the respective coolant fluid.

As depicted in Figure 4, the thermal regulation system 100 may also include a pressure sensor 144 and a temperature sensor 146 associated with the back-up system fluid circuit 22. The pressure sensor 144 is operably connected to the back-up system fluid conduit 106 for detecting a pressure of the back-up system coolant fluid 26. The temperature sensor 146 is operably connected to the back-up system fluid conduit 106 for detecting a temperature of the back-up system coolant fluid 26. In this embodiment, the pressure sensor 144 and the temperature sensor 146 are positioned downstream from the heat exchanger 108 and upstream from the back-up system 14 to detect the pressure and the temperature of the back-up system coolant fluid 26 upon exiting the heat exchanger 108. It is contemplated that, in alternative embodiments, the pressure sensor 144 and the temperature sensor 146 may be positioned anywhere along the back-up system fluid circuit 22. It is further contemplated that any type and any number of sensors may be operably connected to the back-up system fluid conduit 106 to detect the fluid properties of the back-up system coolant fluid 26.

As depicted in Figure 7, the thermal regulation system 100 includes a pressure sensor 148 and a temperature sensor 150 associated with the intermediate fluid circuit 114. The pressure sensor 148 is operably connected to the intermediate fluid conduit 116 for detecting a pressure of the intermediate coolant fluid 118. The temperature sensor 150 operably connected to intermediate fluid conduit 116 for detecting a temperature of the intermediate coolant fluid 118. In this embodiment, the pressure sensor 148 and the temperature sensor 150 are disposed downstream from the first heat exchanger 110 and upstream from the second heat exchanger 112 to detect the pressure and the temperature of the intermediate coolant fluid 118 upon exiting the first heat exchanger 110. It is contemplated that, in alternative embodiments, the pressure sensor 148 and the temperature sensor 150 may be positioned anywhere along the intermediate fluid circuit 114. It is further contemplated that any type and any number of sensors may be operably connected to the intermediate fluid conduit 116 to detect the fluid properties of the intermediate coolant fluid 118.

Although not depicted, it is appreciated that any number and type of sensors may be associated with the data center fluid circuit 20 and operably connected to the data center fluid conduit 104 to detect fluid properties of the data center coolant fluid 24.

It is contemplated that the thermal regulation system 100 may utilize any combination of sensor(s), that is type and/or number, associated with the data center fluid circuit 20, the back-up system fluid circuit 22, and the intermediate fluid circuit 114 (if applicable). It is further contemplated that the sensor(s) may be omitted.

With reference to Figures 2 to 7, the thermal regulation system 100 further includes at least one electrical resistor 152 for further heating the temperature of the back-up system coolant fluid 26 upstream from the back-up system 14. It is appreciated that, in some embodiments, the electrical resistor 152 may be omitted.

In some embodiments, the thermal regulation system 100 includes a controller (not shown) communicatively connected to at least one of: the first bypass system 124, the second bypass system 126, and the intermediate bypass system 136 (if applicable). The controller may selectively actuate the respective bypass system 124, 126, 136 to redirect the flow of the respective fluid circuit 20, 22, 114. The controller may be configured to receive a signal from the sensors 144, 146, 148, 150 and based on the signal received by the controller, the controller may actuate the respective bypass system 124, 126, 136. In one specific example, with reference to the thermal regulation system 100 depicted in Figure 4, the controller may receive a signal from the pressure sensor 144 and/or a signal from the temperature sensor 146. In response to the signal(s) received, the controller actuates the second bypass system 126 to redirect the back-up system coolant fluid 26 either towards or away from the heat transfer module 102.

In some embodiments, the controller is communicatively connected to at least one of the pump(s) 140, 142 associated with the back-up system fluid circuit 22, the intermediate fluid circuit 114 (if applicable), and the data center fluid circuit 20. The controller may selectively actuate the respective pump(s) 140, 142. The controller may be configured to receive a signal from the sensors 144, 146, 148, 150 and based on the signal received by the controller, the controller may actuate the respective pump(s) 140, 142.

In some embodiments, the controller is communicatively connected to the at least one electrical resistor 152. The controller may selectively actuate the electrical resistors 152 to further heat the back-up system coolant fluid 26 prior to circulating through the back-up system 14. The controller may be configured to receive a signal from the temperature sensor 146 associated with the back-up system fluid circuit 22 to detect the temperature of the back-up system coolant fluid 26. In response to receiving the signal, the controller may actuate the electrical resistors 152 to provide additional heating, if necessary.

It is contemplated that, in alternative embodiments, the controller may be omitted.

With reference to Figure 8, the thermal regulation system 100 is connectable to the back-up system 14 via connectors 154, 156. The connectors 154, 156 may be configured to adapt to various back-up system configurations. In some embodiments, the connectors 154, 156 include a first connector 154 to connect the thermal regulation system 100 to the data center 12 and a second connector 156 to connect the thermal regulation system 100 to the back-up system 14. This enables the thermal regulation system 100 to be adaptable to various configurations of the back-up system 14, scalable for larger data centers 12, and enables retrofitting of older data center 12 and back-up system 14 configurations. In certain embodiments, the first and second connectors 154, 156 are 3/4" free nuts. It is contemplated that, in alternative embodiments, the first and second connectors 154, 156 may be any other size and/or other type of connector. Although the first and second connectors 154, 156 are described as being the same size and type of connector, it is appreciated that, in other embodiments, the first and second connectors 154, 156 may have different configurations from one another.

In some embodiments, the thermal regulation system 100 may be disposed within a container containing the back-up system 14 and the second connector 156 is connected to the back-up system 14. The first connector 154 may be positioned exterior of the container to connect to the thermal regulation system 100. Thus, the connectors 154, 156 fluidly connect the thermal regulation system 100 to the back-up system 14.

Although the thermal regulation system 100 has been described as transferring heat from the data center coolant fluid 24 to the back-up system coolant fluid 26 (thus, heating the back-up system coolant fluid 26 and cooling the data center coolant fluid 24), it is appreciated that the thermal regulation system 100 may instead provide cooling of the back-up system coolant fluid 26. In other words, within the heat transfer module 102, the back-up system coolant fluid 26 may have a higher temperature than the data center coolant fluid 24. Thus, heat may be transferred from the back-up system coolant fluid 26 to the data center coolant fluid 24, such that the temperature of the back-up system coolant fluid 26 is lowered and the temperature of the data center coolant fluid 24 is raised.

Although the various features of the thermal regulation system 100 have been described separately, it is appreciated that any combination of these features may be utilized, and the embodiments disclosed are exemplary.

As presented herein, the disclosed embodiments provide the thermal regulation system 100 of the back-up system 14 for the data center 12. The embodiments presented herein disclose thermally connecting the back-up system 14 with the cooling system of the data center 12. That is, the embodiments presented herein disclose using excess thermal energy from the data center 12 to pre-heat and/or maintain temperature of the back-up system 14. The thermal regulation system 100 includes the heat transfer module 102 to thermally connect the data center 12 and the back-up system 14. Specifically, the heat transfer module 102 facilitates transferring heat from the data center coolant fluid 24 to the back-up system coolant fluid 26. As disclosed herein, the back-up coolant fluid 26 may circulate through the back-up system thermal module 109 to transfer heat from the back-up coolant fluid 26 to the internal coolant fluid 107. In other words, the back-up system thermal module 109 thermally connects the back-up system 14 with the data center 12 via the thermal regulation system 100. Alternatively, the back-up system coolant fluid 26 may then circulate directly through the back-up system 14 to pre-heat and/or maintain the back-up system 14 to the predetermined temperature.
The disclosed embodiments of the thermal regulation system 100 provide various benefits including, but not limited to, a reduction in energy consumption by utilizing the excess thermal energy from the data center 12 which reduce or eliminate the need for additional electrical heaters associated with the back-up system 14. The reduction in energy consumption may lead to significant cost savings in the data center 12 operating expenses (associated with the reduced energy consumption itself) and in capital expenditures (associated with reduced or eliminated need for maintaining, repair and/or providing additional electrical heaters). Additionally, the reduction in energy consumption reduces the carbon footprint of the data center 12, contributing to a greener data center operation. The adaptability of the thermal regulation system 100 to connect to various back-up systems 14 configurations via connectors 154,156 may provide users with the ability to scale the thermal regulation system 100 (allowing for the thermal regulation system 100 to accommodate data centers of different sizes and layouts), as well as the ability to retrofit existing data centers without requiring major infrastructure changes.

## Claims

1. A datacenter system (10), comprising:
a datacenter (12);
a back-up power system (14) configured to supply electrical power to the datacenter (12) in case of an electrical power supply grid disruption;
a thermal regulation system (100) for pre-heating the back-up power system (14), the thermal regulation system (100) comprising:
a heat transfer module (102) configured to thermally couple the back-up power system (14) to the datacenter (12);
a first fluid conduit (104) circulating a first coolant fluid (24) from the data center (12) and through the heat transfer module (102);
a second fluid conduit (106) circulating a second coolant fluid (26) through the heat transfer module (102) and to the back-up power system (14); and
the first fluid conduit (104) and the second fluid conduit (106) are thermally connected via the heat transfer module (102) such that heat is transferred from the first coolant fluid (24) to the second coolant fluid (26) for circulation to the back-up power system (14),
**characterized in that** in response to the transfer of heat from the first coolant fluid (24) to the second coolant fluid (26), the back-up power system (14) is pre-heated by the transfer of heat to a predetermined temperature to minimize the effects of cold weather conditions on the back-up power system (14).

2. The datacenter system (10) of claim 1, further comprising at least one of:
a first fluid bypass system (124) fluidly connected to the first fluid conduit (104) for bypassing flow of the first coolant fluid (24) through the heat transfer module (102); and
a second fluid bypass system (126) fluidly connected to the second fluid conduit (106) for bypassing flow of the second coolant fluid (26) through the heat transfer module (102).

3. The datacenter system (10) of claim 1 or 2, further comprising a sensor (144, 146) operably connected to the second fluid conduit (106) for detecting a fluid property of the second coolant fluid.

4. The datacenter system (10) of any one of claims 1 to 3, wherein the heat transfer module (102) comprises a heat exchanger (108), wherein the first fluid conduit (104) is configured to circulate the first coolant fluid (24) through the heat exchanger (108) and the second fluid conduit (106) is configured to circulate the second coolant fluid (26) through the heat exchanger (108).

5. The datacenter system (10) of any one of claims 1 to 3, wherein the heat transfer module (102) comprises:
a first heat exchanger (110), wherein the first fluid conduit (104) is configured to circulate the first coolant fluid (24) through the first heat exchanger (110);
a second heat exchanger (112), wherein the second fluid conduit (106) is configured to circulate the second coolant fluid (26) through the second heat exchanger (112);
an intermediate fluid conduit (116) configured to circulate an intermediate coolant fluid (118), the intermediate fluid conduit (116) comprising:
a first portion (120) configured to circulate the intermediate coolant fluid (118) through the first heat exchanger (110); and
a second portion (122) configured to circulate the intermediate coolant (118) through the second heat exchanger (112);
the first fluid conduit (104) and the first portion (120) of the intermediate fluid conduit (116) are thermally connected via the first heat exchanger (110) such that heat is transferred from the first fluid coolant to the intermediate coolant fluid flowing through the first portion; and
the second fluid conduit (106) and the second portion(122) of the intermediate fluid conduit (116) are thermally connected via the second heat exchanger such (112) that heat is transferred from the second coolant fluid to the intermediate coolant fluid flowing through the second portion.

6. The datacenter system (10) of anyone of claims 1 to 5, wherein the back-up power system (14) comprises a back-up generator.

7. A kit for a thermal regulation system (100) configured to pre-heat a datacenter back-up power system (14) that supplies electric power in case of an electrical power supply grid disruption, the kit comprising:
the datacenter system of any one of claims 1 to 6 that further includes a first connector (154) configured to connect the thermal regulation system (100) to the datacenter (12) and a second connector (156) configured to connect the thermal regulation system (100) to the back-up power system (14).

8. The datacenter system (10) of any one of claims 1 to 6 further comprising a dry cooler (16) fluidly connected to at least one of the data center (12) and the thermal regulation system (100).

9. The datacenter system (10) of any one of claims 1 to 6 or 8, wherein the back-up power system (14) does not have an independent thermal regulation system (100).

## Patentansprüche

1. Datenzentrumssystem (10), umfassend:
ein Datenzentrum (12);
ein Sicherungsleistungssystem (14), das konfiguriert ist, um dem Datenzentrum (12) im Falle einer Störung des Stromversorgungsnetzes Strom zuzuführen;
ein Wärmeregulierungssystem (100) zum Vorwärmen des Sicherungsleistungssystems (14), wobei das Wärmeregulierungssystem (100) Folgendes umfasst:
ein Wärmeübertragungsmodul (102), das konfiguriert ist, um das Sicherungsleistungssystem (14) thermisch an das Datenzentrum (12) zu koppeln;
eine erste Fluidleitung (104), in der ein erstes Kühlmittelfluid (24) von dem Datenzentrum (12) und durch das Wärmeübertragungsmodul (102) zirkuliert;
eine zweite Fluidleitung (106), in der ein zweites Kühlmittelfluid (26) durch das Wärmeübertragungsmodul (102) und zu dem Sicherungsleistungssystem (14) zirkuliert; und
wobei die erste Fluidleitung (104) und die zweite Fluidleitung (106) über das Wärmeübertragungsmodul (102) thermisch derart verbunden sind, dass Wärme von dem ersten Kühlmittelfluid (24) auf das zweite Kühlmittelfluid (26) zur Zirkulation zu dem Sicherungsleistungssystem (14) übertragen wird,
**dadurch gekennzeichnet, dass**
das Sicherungsleistungssystem (14) als Reaktion auf die Übertragung von Wärme von dem ersten Kühlmittelfluid (24) auf das zweite Kühlmittelfluid (26) durch die Übertragung von Wärme auf eine vorbestimmte Temperatur vorgewärmt wird, um die Auswirkungen kalter Witterungsbedingungen auf das Sicherungsleistungssystem (14) zu minimieren.

2. Datenzentrumssystem (10) nach Anspruch 1, ferner umfassend mindestens eines von Folgenden:
ein erstes Fluidumleitungssystem (124), das mit der ersten Fluidleitung (104) fluidverbunden ist, um eine Strömung des ersten Kühlmittelfluids (24) durch das Wärmeübertragungsmodul (102) umzuleiten; und
ein zweites Fluidumleitungssystem (126), das mit der zweiten Fluidleitung (106) fluidverbunden ist, um eine Strömung des zweiten Kühlmittelfluids (26) durch das Wärmeübertragungsmodul (102) umzuleiten.

3. Datenzentrumssystem (10) nach Anspruch 1 oder 2, ferner umfassend einen Sensor (144, 146), der mit der zweiten Fluidleitung (106) wirkverbunden ist, um eine Fluideigenschaft des zweiten Kühlmittelfluids zu erfassen.

4. Datenzentrumssystem (10) nach einem der Ansprüche 1 bis 3, wobei das Wärmeübertragungsmodul (102) einen Wärmetauscher (108) umfasst, wobei die erste Fluidleitung (104) konfiguriert ist, um das erste Kühlmittelfluid (24) durch den Wärmetauscher (108) zirkulieren zu lassen, und die zweite Fluidleitung (106) konfiguriert ist, um das zweite Kühlmittelfluid (26) durch den Wärmetauscher (108) zirkulieren zu lassen.

5. Datenzentrumssystem (10) nach einem der Ansprüche 1 bis 3, wobei das Wärmeübertragungsmodul (102) Folgendes umfasst:
einen ersten Wärmetauscher (110), wobei die erste Fluidleitung (104) konfiguriert ist, um das erste Kühlmittelfluid (24) durch den ersten Wärmetauscher (110) zirkulieren zu lassen;
einen zweiten Wärmetauscher (112), wobei die zweite Fluidleitung (106) konfiguriert ist, um das zweite Kühlmittelfluid (26) durch den zweiten Wärmetauscher (112) zirkulieren zu lassen;
eine Zwischenfluidleitung (116), die konfiguriert ist, um ein Zwischenkühlmittelfluid (118) zirkulieren zu lassen, wobei die Zwischenfluidleitung (116) Folgendes umfasst:
einen ersten Abschnitt (120), der konfiguriert ist, um das Zwischenkühlmittelfluid (118) durch den ersten Wärmetauscher (110) zirkulieren zu lassen; und
einen zweiten Abschnitt (122), der konfiguriert ist, um das Zwischenkühlmittel (118) durch den zweiten Wärmetauscher (112) zirkulieren zu lassen;
wobei die erste Fluidleitung (104) und der erste Abschnitt (120) der Zwischenfluidleitung (116) über den ersten Wärmetauscher (110) derart thermisch verbunden sind, dass Wärme von dem ersten Fluidkühlmittel auf das durch den ersten Abschnitt strömende Zwischenkühlmittelfluid übertragen wird; und
wobei die zweite Fluidleitung (106) und der zweite Abschnitt (122) der Zwischenfluidleitung (116) über den zweiten Wärmetauscher (112) derart thermisch verbunden sind, dass Wärme von dem zweiten Kühlmittelfluid auf das durch den zweiten Abschnitt strömende Zwischenkühlmittelfluid übertragen wird.

6. Datenzentrumssystem (10) nach einem der Ansprüche 1 bis 5, wobei das Sicherungsleistungssystem (14) einen Sicherungsgenerator umfasst.

7. Einrichtung für ein Wärmeregulierungssystem (100), das konfiguriert ist, um ein Sicherungsleistungssystem (14) eines Datenzentrums, das im Falle einer Störung des Stromversorgungsnetzes Strom zuführt, vorzuwärmen, wobei die Einrichtung Folgendes umfasst:
das Datenzentrumssystem nach einem der Ansprüche 1 bis 6, das ferner einen ersten Verbinder (154), der konfiguriert ist, um das Wärmeregulierungssystem (100) mit dem Datenzentrum (12) zu verbinden, und einen zweiten Verbinder (156), der konfiguriert ist, um das Wärmeregulierungssystem (100) mit dem Sicherungsleistungssystem (14) zu verbinden, beinhaltet.

8. Datenzentrumssystem (10) nach einem der Ansprüche 1 bis 6, ferner umfassend einen Trockenkühler (16), der mit mindestens einem von dem Datenzentrum (12) und dem Wärmeregelungssystem (100) fluidverbunden ist.

9. Datenzentrumssystem (10) nach einem der Ansprüche 1 bis 6 oder 8, wobei das Sicherungsleistungssystem (14) kein unabhängiges Wärmeregulierungssystem (100) aufweist.

## Revendications

1. Système de centre de données (10), comprenant :
un centre de données (12) ;
un système d'alimentation de secours (14) configuré pour fournir de l'énergie électrique au centre de données (12) en cas de perturbation du réseau d'alimentation électrique ;
un système de régulation thermique (100) pour préchauffer le système d'alimentation de secours (14), le système de régulation thermique (100) comprenant :
un module de transfert de chaleur (102) configuré pour coupler thermiquement le système d'alimentation de secours (14) au centre de données (12) ;
un premier conduit de fluide (104) faisant circuler un premier fluide de refroidissement (24) depuis le centre de données (12) et à travers le module de transfert de chaleur (102) ;
un second conduit de fluide (106) faisant circuler un second fluide de refroidissement (26) à travers le module de transfert de chaleur (102) et vers le système d'alimentation de secours (14) ; et
le premier conduit de fluide (104) et le second conduit de fluide (106) sont thermiquement connectés via le module de transfert de chaleur (102) de sorte que la chaleur est transférée du premier fluide de refroidissement (24) au second fluide de refroidissement (26) pour la circulation vers le système d'alimentation de secours (14),
**caractérisé en ce que**
en réponse au transfert de chaleur du premier fluide de refroidissement (24) au second fluide de refroidissement (26), le système d'alimentation de secours (14) est préchauffé par le transfert de chaleur à une température prédéterminée afin de minimiser les effets des conditions météorologiques froides sur le système d'alimentation de secours (14).

2. Système de centre de données (10) selon la revendication 1, comprenant en outre au moins un des éléments suivants :
un premier système de dérivation de fluide (124) connecté fluidiquement au premier conduit de fluide (104) pour dévier le flux du premier fluide de refroidissement (24) à travers le module de transfert de chaleur (102) ; et
un second système de dérivation de fluide (126) connecté fluidiquement au second conduit de fluide (106) pour dériver le flux du second fluide de refroidissement (26) à travers le module de transfert de chaleur (102).

3. Système de centre de données (10) selon la revendication 1 ou 2, comprenant en outre un capteur (144, 146) connecté de manière opérationnelle au second conduit de fluide (106) pour détecter une propriété de fluide du second fluide de refroidissement.

4. Système de centre de données (10) selon l'une quelconque des revendications 1 à 3, dans lequel le module de transfert de chaleur (102) comprend un échangeur de chaleur (108), dans lequel le premier conduit de fluide (104) est configuré pour faire circuler le premier fluide de refroidissement (24) à travers l'échangeur de chaleur (108) et le second conduit de fluide (106) est configuré pour faire circuler le second fluide de refroidissement (26) à travers l'échangeur de chaleur (108).

5. Système de centre de données (10) selon l'une quelconque des revendications 1 à 3, dans lequel le module de transfert de chaleur (102) comprend :
un premier échangeur de chaleur (110), dans lequel le premier conduit de fluide (104) est configuré pour faire circuler le premier fluide de refroidissement (24) à travers le premier échangeur de chaleur (110) ;
un second échangeur de chaleur (112), dans lequel le second conduit de fluide (106) est configuré pour faire circuler le second fluide de refroidissement (26) à travers le second échangeur de chaleur (112) ;
un conduit de fluide intermédiaire (116) configuré pour faire circuler un fluide de refroidissement intermédiaire (118), le conduit de fluide intermédiaire (116) comprenant :
une première partie (120) configurée pour faire circuler le fluide de refroidissement intermédiaire (118) à travers le premier échangeur de chaleur (110) ; et
une seconde partie (122) configurée pour faire circuler le fluide de refroidissement intermédiaire (118) à travers le second échangeur de chaleur (112) ;
le premier conduit de fluide (104) et la première partie (120) du conduit de fluide intermédiaire (116) sont connectés thermiquement via le premier échangeur de chaleur (110) de sorte que la chaleur est transférée du premier fluide de refroidissement au fluide de refroidissement intermédiaire circulant dans la première partie ; et
le second conduit de fluide (106) et la seconde partie (122) du conduit de fluide intermédiaire (116) sont thermiquement connectés via le second échangeur de chaleur (112) de sorte que la chaleur est transférée du second fluide de refroidissement au fluide de refroidissement intermédiaire circulant dans la seconde partie.

6. Système de centre de données (10) selon l'une quelconque des revendications 1 à 5, dans lequel le système d'alimentation de secours (14) comprend un générateur de secours.

7. Kit pour un système de régulation thermique (100) configuré pour préchauffer un système d'alimentation de secours de centre de données (14) qui fournit de l'énergie électrique en cas d'interruption du réseau d'alimentation électrique, le kit comprenant :
le système de centre de données selon l'une quelconque des revendications 1 à 6 qui comporte en outre un premier connecteur (154) configuré pour connecter le système de régulation thermique (100) au centre de données (12) et un second connecteur (156) configuré pour connecter le système de régulation thermique (100) au système d'alimentation de secours (14).

8. Système de centre de données (10) selon l'une quelconque des revendications 1 à 6 comprenant en outre un refroidisseur sec (16) connecté fluidiquement à au moins l'un du centre de données (12) et du système de régulation thermique (100).

9. Système de centre de données (10) selon l'une quelconque des revendications 1 à 6 ou 8, dans lequel le système d'alimentation de secours (14) ne dispose pas d'un système de régulation thermique (100) indépendant.
